## Europäisches Patentamt

## European Patent Office

## Office européen des brevets

(19)

(11) Veröffentlichungsnummer: **0 028 786**
**B1**

(12) **EUROPÄISCHE PATENTSCHRIFT**

(45) Veröffentlichungstag der Patentschrift:
14.03.84

(51) Int. Cl.³: **H 01 L 21/00**

(21) Anmeldenummer: **80106741.4**

(22) Anmeldetag: **03.11.80**

(54) Ionenimplantationsverfahren.

(30) Priorität: **13.11.79 DE 2945854**

(43) Veröffentlichungstag der Anmeldung:
**20.05.81 Patentblatt 81/20**

(45) Bekanntmachung des Hinweises auf die Patenterteilung:
**14.03.84 Patentblatt 84/11**

(84) Benannte Vertragsstaaten:
**CH DE FR GB IT LI NL**

(56) Entgegenhaltungen:
FR - A - 2 249 435
FR - A - 2 260 186
FR - A - 2 260 187
FR - A - 2 275 888
FR - A - 2 371 779
US - A - 3 837 856

FUNKSCHAU, Band 51, Nr. 8, 12. April 1979, München, DE, H. SCHAUMBERG: "Lithografietechniken für höchstintegrierte Schaltungen", Seiten 431-434

(73) Patentinhaber: **Deutsche ITT Industries GmbH, Hans-Bunte-Strasse 19 Postfach 840, D-7800 Freiburg (DE)**

(84) Benannte Vertragsstaaten: **DE**

(73) Patentinhaber: **ITT INDUSTRIES INC., 320 Park Avenue, New York, NY 10022 (US)**

(84) Benannte Vertragsstaaten: **CH FR GB IT LI NL**

(72) Erfinder: **Hiss, Ludwig, Ing. grd., Schwobthalerstrasse 26, D-7833 Emmendingen (DE)**
Erfinder: **Waldvogel, Ulrich, Dipl.-Phys., Vogesenstrasse 16, D-7831 Sexau (DE)**

(74) Vertreter: **Stutzer, Gerhard, Dr., Deutsche ITT Industries GmbH Patent- und Lizenzabteilung Hans-Bunte-Strasse 19 Postfach 840, D-7800 Freiburg (DE)**

## lonenimplantationsverfahren

Die Erfindung betrifft ein lonenimplantationsverfahren gemäß dem Oberbegriff des Anspruchs 1.

Bei einem Ionenimplantationsverfahren zum Herstellen von Halbleiterbauelementen, wie es aus der Zeitschrift »Solid-State Electronics« (1972) Band 15, Seiten 165 bis 175 bekannt ist, wird eine oberflächlich in einem Halbleiterkörper angeordnete Substratzone unter Verwendung einer Oxidmaske, welche mit Hilfe einer Lackmaske photolithographisch hergestellt wurde, durch Implantation von Ionen, welche anschließend in die Substratzone tiefer eindiffundiert werden, hergestellt. Bei diesem Verfahren werden zur Begrenzung der Zonenflächen bei der lonenimplantation ausschließlich Oxidmasken verwendet.

Die ausschließliche Verwendung von Oxidmasken hat den Nachteil, daß nach jeder Implantation die Neubildung einer Oxidschicht insbesondere bei einer folgenden Nachdiffusion, erforderlich ist. Aus der FR-A-2 260 187 ist ein lonenimplantationsverfahren zum Herstellen von Halbleiterbauelementen mit Zonen unterschiedlicher Dotierungen in einem Halbleitersubstrat bekannt, bei welchem Verfahren unter Verwendung von unterschiedlich strukturierten Photolackmasken die außerhalb der Flächen der Zonen liegenden Oberflächenteile der Oberfläche eines Substrats gegen eine Implantation von Ionen maskiert werden. Die Photolackmasken sind über eine solch dünne Isolierschicht mit der Substratoberfläche verbunden, daß bei der Implantation der Ionen die Isolierschicht durchdrungen werden kann. Bei dem bekannten Verfahren wird jeweils nach der Ionenimplantation in die Substratoberfläche durch die Öffnungen der betreffenden Photolackmaske mit bestimmten Ionen in einer bestimmten Menge der Photolack durch einen Plasmaätzprozeß abgetragen und abschließend die in Form von Ionen implantierte Verunreinigungen in das Substrat diffundiert.

Auch bei diesem Verfahren wird der Photolack nicht unmittelbar auf die praktisch saubere Substratoberfläche aufgebracht, sondern über eine Isolierschicht, die in einem besonderen Arbeitsprozeß hergestellt wird. Man war in der Fachwelt wohl der Ansicht, daß zur Abgrenzung von Zonenflächen bei der Implantation Photolackmasken, die zumindest teilweise unmittelbar auf die Substratoberfläche aufgebracht werden, kaum geeignet sind.

Die Erfindung geht aus von dem bekannten Verfahren der vorstehend genannten FR-A-2 260 187 und betrifft ein Verfahren gemäß dem Oberbegriff des Anspruchs 1.

Dieses Verfahren hat den Nachteil, daß die Photolackmasken auf eine anfänglich auf die Substratoberfläche aufgebrachte Isolierschicht aufgebracht wird. Diese muß so dünn bemessen werden, daß die Ionen sie durchdringen können. Aufgabe der Erfindung ist die Weiterbildung des bekannten Verfahrens, so daß ohne wesentliche Verschlechterung der Haftung des Photolacks und ohne Anwendung eines zusätzlichen Prozesses die Verwendung dickerer Isolierschichten möglich ist.

Diese Aufgabe wird erfindungsgemäß durch die Kombination der im kennzeichnenden Teil des Anspruch 1 angegebenen Maßnahmen gelöst.

Bei dem Verfahren nach der Erfindung kommt zur Entfernung der Photolackmaske nach jedem Implantationsschritt ein Plasmaätzschritt zur Anwendung, wobei Ionen eines Oxidationsmittels im Vakuum den Photolack oxidieren und die Oxidationsprodukte mit sonstigen Verunreinigungen abgesaugt werden. Ein solches Reinigungsverfahren ist aus der Zeitschrift »SCP and Solid-State Technology« (Dezember 1967) Seiten 33 bis 38 bekannt. Es wurde festgestellt, daß eine auf solche Weise erfolgende Reinigung bei der Entfernung der Lackmasken ohne weiteres reproduzierbare und für die Aufbringung weitere Photolackmasken mit anschließender Implantation ausreichend saubere Oberfläche mit guten Hafteigenschaften hinsichtlich des Photolacks ergibt und die Qualität bereits implantierter Zonen nicht beeinträchtigt.

Das Verfahren der Erfindung findet vorzugsweise seine Anwendung bei der Herstellung von integrierten Schaltungen mit einer Mehrzahl von Schaltungskomponenten, welche unterschiedlich dotierte Zonen aufweisen. Unter unterschiedlich dotierten Zonen werden hier Zonen verstanden, welche in der Dotierungskonzentration und/oder hinsichtlich des zu erzielenden Leitungstyps unterschiedliche Dotierungen aufweisen. Das Verfahren der Erfindung kann natürlich auch insofern weitergebildet werden, als auch unterschiedlich stark dotierte Bereiche an der Substratoberfläche in gleicher Weise wie pn-Übergänge bildende Zone erzeugt werden können.

Das Verfahren nach der Erfindung kann sowohl zur Erzeugung von bipolaren als auch unipolaren Schaltungskomponenten in monolithisch integrierten Festkörperschaltungen herangezogen werden.

Eine bevorzugte Anwendung zur Herstellung eines Paares von komplementären Isolierschicht-Feldeffekttransistoren als Schaltungsteil einer monolithisch integrierten Schaltung, die in der Mehrzahl an einer in die einzelnen integrierten Festkörperschaltungen zu zerteilenden Halbleiterplatte erfolgt, wird im folgenden anhand der Zeichnung erläutert, deren Figuren in üblicher Querschnitts-Schrägansicht die einzelnen das Verfahren der Erfindung betreffenden Arbeitsgänge veranschaulichen.

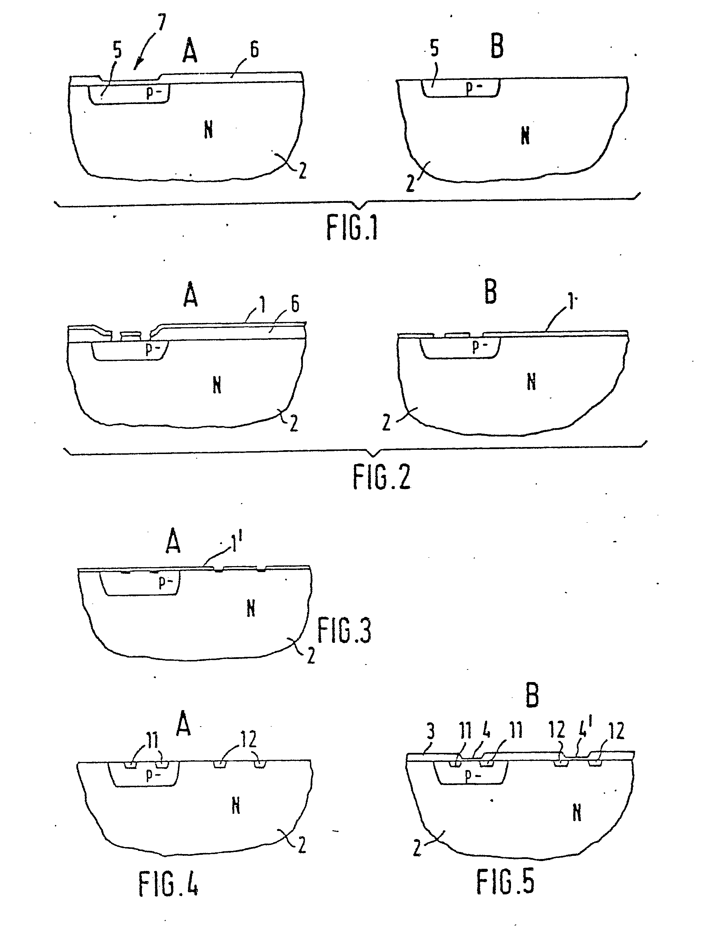

Bei der Herstellung der monolithisch integrierten Schaltung mit Paaren von komplementären Isolierschicht-Feldeffekttransistoren enthaltenden Schaltungsteilen wird, wie die Fig. 1A und

1B veranschaulichen, von einem plattenförmigen Substrat 2 ausgegangen, in dessen einer Oberflächenseite inselförmige, je einen sperrenden pn-Übergang bildende Planarzonen 5 zur Aufnahme der Isolierschicht-Feldeffekttransistoren des einen Leitungstyps, eingesetzt sind. Zu diesem Zweck wird in bekannter Weise gemäß der Fig. 1A die Oxidmaskierungsmaske 6 mit dem Diffusionsfenster 7 auf das Substrat 2 aufgebracht und bei Verwendung eines n-dotierten Substrats p-dotierendes Verunreinigungsmaterial, vorzugsweise Bor, innerhalb des Diffusionsfensters in die Substratoberfläche mit einer solchen Konzentration implantiert, daß eine schwach p-leitende Planarzone 5 nach dem auf den Implantationsprozeß folgende Diffusionsprozeß entsteht. Danach hat sich innerhalb des Diffusionsfensters 7 eine Oxidschicht in einer Dicke weniger als die der Oxidmaskierungsmaske 6 gebildet, wie die Fig. 1A veranschaulicht.

In Anlehnung an das Verfahren nach der Erfindung wird aber die Verwendung einer Photolackmaskierungsmaske mit einem Diffusionsfenster zur Begrenzung der Planarzone 5 vorgezogen, welche in gleicher Weise wie bei dem Verfahren nach der Erfindung unter Anwendung eines Plasmareinigungsprozesses nach dem Einbringen der erforderlichen Dotierungsmaterialmenge in die Substratoberfläche entfernt wird. Nach der Diffusion der Planarzone 5 wird ein Reinigungsprozeß der Substratoberfläche durchgeführt, so daß eine ebene Fläche erhalten wird, wie die Fig. 1B veranschaulicht.

Eine solche ebene Oberfläche ist als Grundlage für die nach dem Verfahren der Erfindung aufgebrachte Photolackmaske 1 gemäß der Fig. 2B wesentlich besser geeignet als die gemäß der Fig. 2A teilweise über die Oberflächenseite des Substrats 2 sich erstreckende Isolierschicht der Oxidmaskierungsmaske 6. Die Photolackmaske 1 ist in beiden Fällen A bzw. B derart strukturiert, daß die Flächen der herzustellenden Zone 11, nämlich die der Source-Zone und die der Drain-Zone des n-Kanal-Feldeffekttransistors, ausschließlich durch die Photolackmaske 1 begrenzt sind.

Nach der Implantation von Phosphoratomen in für die herzustellenden Zonen ausreichender Menge wird anschließend die Substratoberfläche unter Anwendung eines oxidierenden Plasmaätzprozesses freigelegt und sorgfältig gereinigt, so daß lediglich der am Ende des Ätzprozesses entstehende und unvermeidlich durch den Sauerstoffgehalt der Luft bedingte dünne Oxidfilm verbleibt.

Danach wird in beiden Fällen die Photolackmaske 1' unter Verwendung einer Photomaske entsprechend der üblichen photolithographischen Technik mit den beiden für die erforderlichen Zonen 12 benötigten Öffnungen, welche die Begrenzung der Zonenflächen ergeben, aufgebracht und die freiliegenden Substratoberfläche durch die Öffnung der Photolackmaske 1' mit p-dotierenden Verunreinigungsionen in einer bestimmten Menge bestrahlt, wobei der außerhalb der Flächen der Zonen liegende Oberflächenteil der Substratoberfläche von der Photolackmaske 1' maskiert ist. Danach sind in die Substratoberfläche an den erforderlichen Stellen die Dotierungen für die Zonen der Isolierschicht-Feldeffekttransistoren unterschiedlichen Leitungstyps eingebracht, wie die Fig. 3 veranschaulicht.

Durch das wiederholte Aufbringen von unterschiedlich strukturierten Photolackmasken können nach jedem Ionenimplantationsprozeß und danach erfolgender Abtragung des Photolacks durch einen oxidierenden Plasmaätzprozeß, bei dem eine leicht oxidierte Substratoberfläche mit sehr guten Hafteigenschaften hinsichtlich des Photolacks gewährleistet ist, beliebig viel Zonenstrukturen beliebiger Konzentration und beliebigen Leitungstyps nacheinander insofern vorbereitet werden, als lediglich abschließend ein einziger Diffusionsprozeß bei den relativ hohen zur Diffusion der Dotierungen erforderlichen Temperaturen zur Anwendung kommt. Da erfahrungsgemäß nur bei derartigen Hochtemperaturprozessen sich kristallschädigende Störungen über das Substrat ausbreiten können, ist eine maximale Ausbeute gewährleistet, die über 90% liegt.

Nach der Diffusion der in Form von Ionen implantierten Verunreinigungsatomen werden monolithisch integrierte Festkörperschaltungen mit Strukturen gemäß der Fig. 4 erhalten.

Anhand der Fig. 5 wird nun eine besonders vorteilhafte Weiterbildung des Ionenimplantationsverfahrens nach der Erfindung beschrieben. Die Substratoberfläche wird nach dem erwähnten letzten Ionenimplantationsprozeß mit einer bei der Temperatur des erforderlichen Diffusionsprozesses beständigen Isolierschicht 3, vorzugsweise aus Siliciumdioxid, bedeckt, die aus der Gasphase abgeschieden wird. Anschließend werden die über den Bereichen der Kanalzonen liegenden Isolierschichtteile entfernt und die Diffusion der Verunreinigungsatome in oxidierender Atmosphäre, beispielsweise in einer mit einem Trägergas verdünnten Wasserdampfatmosphäre durchgeführt. Dabei werden die Prozeßparameter, insbesondere die Zusammensetzung der oxidierenden Atmosphäre derart gewählt, daß während der zur Bildung der Zonen erforderlichen Diffusionszeit die Gate-Oxidschichten 4 bzw. 4' in der erforderlichen Dicke zwischen den Zonen der Zonenpaare ausgebildet werden. Anschließend können auf diese Gate-Oxidschichten 4 bzw. 4' die Gate-Elektroden aufgebracht werden.

Obwohl das Verfahren nach der Erfindung vorzugsweise seine Anwendung bei integrierten Festkörperschaltungen mit nebeneinander liegenden Zonenstrukturen seine Anwendung findet, wie es bei Festkörperschaltungen mit Isolierschicht-Feldeffekttransistoren der Fall ist, kommt auch eine Anwendung bei ineinander eingesetzten Zonenstrukturen in Frage, wie es bei monolithisch integrierten Festkörperschaltungen mit bipolaren Transistoren der Fall ist. Wie-

derum werden in mehreren Ionenimplantationsprozessen mit unterschiedlich strukturierten Photolackmasken die erforderlichen Dotierungsmengen an den erforderlichen Stellen in die Oberfläche des Substrats eingebracht, wobei jeweils vor dem Aufbringen einer neuen Photolackmaske die bereits verwendete durch einen oxidierenden Plasmaätzprozeß entfernt wurde und erst abschließend der eigentliche Diffusionsprozeß für sämtliche Dotierungen zum Herstellen der Zonen durchgeführt wird. Die relativen Einbringtiefen der Zonen können natürlich nicht durch Wahl der Temperatur und der Zeit eingestellt werden, da nur ein einziger Hochtemperaturprozeß zur Anwendung kommt. Durch Wahl der Dotierungselemente und/oder der Ionenstrahlenergie können jedoch die relativen Eindringtiefen der einzelnen Zonenstrukturen in insbesondere für logische Schaltungen ausreichenden Grenzen variiert werden.

Das Verfahren der Erfindung hat den Vorteil eines sehr geringen apparativen Aufwands mit geringen Arbeitszeiten, da erst abschließend der eigentliche Diffusionsprozeß durchgeführt wird und davor stets die gleichen Arbeitsgänge des Aufbringens des Photolacks, der Belichtung, des Auslösens des Photolackmaterials innerhalb der Photolackmaskierungsfenster, anschließender Implantation unterschiedlicher Dotierungen und danach erfolgenden Plasmaätzprozeß zur Anwendung kommt.

Da zwischen den einzelnen Dotierungsschritten keine maskierenden Siliciumdioxid-Schichten verwendet werden, wird beim Verfahren der Erfindung in vorteilhafter Weise ein unterschiedliches Höhenniveau über verschiedenen Bereichen des Substrats vermieden. Abgesehen von den Kontaktöffnungen kann eine völlig plane Oberfläche erzielt werden, auf die die Leiterbahnen aufgebracht werden. Dies hat den Vorteil, daß Fehler durch Unterbrechungen von Leiterbahnen an Kanten weitgehend ausgeschlossen sind.

**Patentansprüche**

1. Ionenimplantationsverfahren zum Herstellen von Halbleiterbauelementen mit Zonen unterschiedlicher Dotierung in einem Halbleitersubstrat, in dessen ebener Oberfläche die Zonen eingesetzt sind, bei welchem Verfahren

—. unter ausschließlicher Verwendung von unterschiedlich strukturierten Photolackmasken (1) die außerhalb der Flächen der Zonen (11, 12) liegenden Oberflächenteile der Oberfläche des Substrats (2) gegen eine Implantation von Ionen maskiert werden,

— jeweils anschließend die Substratoberfläche durch die Öffnungen der betreffenden Photolackmaske (1; 1') mit bestimmten Ionen in einer bestimmten Menge bestrahlt wird,

— der Photolack danach durch einen Plasmaätzprozeß abgetragen wird und abschließend

— die in Form von Ionen implantierten Verunreinigungen in das Halbleitersubstrat diffundiert werden,

dadurch gekennzeichnet,

— daß die Photolackmasken (1; 1') unmittelbar auf die weitgehend von Isolierschichtteilen (Oxidschichtteilen) befreite saubere Substratoberfläche aufgebracht werden, die höchstens kurzzeitig dem Plasmaoxidationsprozeß zur Entfernung einer bereits verwendeten Photolackmaske ausgesetzt war,

— daß nach dem letzten Plasmaätzprozeß die Oberfläche des Substrats (2) mit einer bei der Diffusionstemperatur der Verunreinigungsatome beständigen Isolierschicht (3) bedeckt wird und

— daß danach die in Form von Ionen implantierten Verunreinigungsatome in das Substrat (2) diffundiert werden.

2. Ionenimplantationsverfahren nach Anspruch 1, gekennzeichnet durch die Begrenzung von Zonenpaaren (11) erster Dotierung einer Mehrzahl von Isolierschicht-Feldeffekttransistoren mittels einer ersten Photolackmaske (1), durch eine Begrenzung von Zonenpaaren (12) zweiter Dotierung einer Mehrzahl von weiteren Isolierschicht-Feldeffekttransistoren mittels einer zweiten Photolackmaske (1') nach Entfernung der ersten Photolackmaske (1), durch die Bedeckung der mittels eines Plasmaätzprozeß freigelegten Oberflächen des Substrats (2) mittels einer aus der Gasphase aufgebrachten Isolierschicht (3), durch die Entfernung des zwischen den Zonen der Zonenpaare (11, 12) liegenden Isolierschichtteile und durch eine Diffusion der Verunreinigungsatome in oxidierender Atmosphäre derart, daß Gate-Oxidschichten (4, 4') erforderlicher Dicke zwischen den Zonen der Zonenpaare (11, 12) gebildet werden.

**Claims**

1. Ion implantation process for manufacturing semiconductor devices having regions of different doping within a semiconductor substrate into the plane surface of which the regions are inserted, in which process

— by exclusive use of differently structured photoresist masks (1) the surface portions of the surface of the substrate (2) lying outside the areas of the regions (11, 12) are masked against an implantation of ions,

— each time subsequently the substrate surface through the openings of the respective photoresist mask (1; 1') with certain ions in a predetermined amount is irradiated,

— the photoresist is subsequently removed by employing a plasma etching process and finally
— the dopings implanted in the form of ions are diffused into the substrate,

characterized in

— that the photoresist masks (1; 1') are directly deposited on the clean substrate surface extensively freed from parts of insulating layers (oxide layer parts) which surface utmostly had been subjected for a short period of time to the plasma oxidation process to remove the already used photoresist mask,
— that, following the last plasma etching process, the surface of the substrate (2) is covered with an insulating layer (3) which remains invariable at the diffusion temperature of the impurity atoms and,
— that subsequently the impurity atoms implanted in the form of ions, are diffused into said semiconductor substrate (2).

2. Ion implantation process as claimed in claim 1, characterized by the limitation of region pairs (11) of a first doping of a plurality of insulated gate field-effect transistors with the aid of a first photoresist mask (1), by a limitation of region pairs (12) of a second doping of a plurality of further insulated gate field-effect transistors with the aid of a second photoresist mask (1') following the removal of said first photoresist mask (1), by covering the surface of said substrate (2) as exposed by way of a plasma etching process, with an insulating layer (3) deposited from the gas phase, by removing the insulatinglayer parts between the regions of the region pairs (11, 12), and by a diffusion of the impurity atoms within an oxidizing atmosphere in such a way that gate-oxide layers (4, 4') of the necessary thickness are formed between the regions of said region pairs (11, 12).

**Revendications**

1. Procédé d'implantation ionique pour réaliser des composants semiconducteurs ayant des zones différemment dopées dans la surface plane d'un substrat semiconducteur, dans lequel:

— en utilisant exclusivement des masques en laque photosensible (1) différemment structurés, on masque contre une implantation d'ions les parties de la surface du substrat (2) situées en dehors des surfaces des zones (11, 12);
— ensuite, à chaque fois, on projette à la surface du substrat, au travers des ouvertures du masque en laque photosensible considéré (1, 1'), une quantitédéterminée d'ions déterminés;
— par un processus d'attaque par plasma, on enlève ensuite la laque photosensible puis, pour terminer,
— on diffuse dans le substrat semiconducteur les impuretés implantées sous forme d'ions;

ce procédé étant caractérisé en ce que:

— les masques en laque photosensible (1, 1') sont appliqués directement sur la surface du substrat propre, complètement débarrassée de parties de couche isolante (parties de couche d'oxyde), cette surface ayant au plus été brièvement exposée à une oxydation sous plasma à l'occasion de l'enlèvement d'un masque en laque photosensible déjà utilisé;
— après le dernier processus d'attaque par plasma, la surface du substrat (2) est couverte d'une couche isolante (3) résistant à la température de diffusion des atomes d'impuretés; et
— les atomes d'impuretés implantés sous forme d'ions sont alors diffusés dans le substrat (2).

2. Procédé d'implantation ionique selon la revendication 1, caractérisé par la délimitation de paires de zones (11) ayant un premier type de dopage et appartenant à une pluralité de transistors à effet de champ á grille isolée, cette délimination étant faite au moyen d'un premier masque en laque photosensible (1); par une délimination de paires de zones (12) ayant un deuxième type de dopage et appartenant à une pluralité d'autres transistors à effet de champ à grille isolée, cette délimination étant faite au moyen d'un deuxième masque en laque photosensible (1') après enlèvement du premier masque en laque photosensible (1); par le recouvrement des surfaces du substrat (2) dégagées au moyen d'un processus d'attaque par plasma, ce recouvrement étant effectué au moyen d'une couche isolante (3) appliquée à partir d'une phase gazeuse; par l'enlèvement des portions de couche isolante se trouvant entre les zones des paires de zones (11, 12); et par une diffusion des atomes d'impuretés effectuée en atmosphère oxydante de façon que de couches d'oxyde (4, 4') ayant l'épaisseur nécessaire pour les électrodes de commande soient formées entre les zones des paires de zones (11, 12).

FIG.1

FIG.2

FIG.3

FIG.4

FIG.5